# FASCICULE DE BREVET EUROPEEN

(11) **EP 2 372 914 B1**
(45) Date de publication et mention de la délivrance du brevet: **21.12.2016**
(21) Numéro de dépôt: 11160624.0
(22) Date de dépôt: 31.03.2011
(51) Int. Cl.: H03K 17/96, H01H 13/702

(54) **Module de commande tactile**
Berührungssteuermodul
Touch control module

(30) Priorité: 31.03.2010 FR 1001333
(43) Date de publication de la demande: 05.10.2011
(73) Titulaire: VALEO SYSTEMES THERMIQUES, 78320 Le Mesnil Saint-Denis (FR)
(72) Inventeur: Huynh, Tan Duc, 93330, NEUILLY SUR MARNE (FR); Vanhelle, Stéphane, 74970, MARIGNIER (FR)
(74) Mandataire: Pothmann, Karsten

(56) Documents cités:
- EP-A1- 1 691 486
- EP-A1- 1 936 480
- WO-A2-2008/009687
- DE-B3-102005 027 572
- DE-U1-202007 017 430
- US-A1- 2007 119 698

## Description

La présente invention concerne un module de commande, en particulier pour véhicule automobile, comportant une dalle tactile.

Plus précisément, un tel module trouve une application avantageuse pour les commandes de la planche de bord.

L'invention peut aussi être appliquée pour les commandes se trouvant au niveau de la console entre les deux sièges avant d'un véhicule automobile pour par exemple commander des fonctions de climatisation, d'un système audio, d'un système de téléphonie ou encore d'un système de navigation, ou en variante dans une région du véhicule appelée le dôme qui se situe au niveau de l'emplacement habituel du rétroviseur intérieur, pour par exemple commander des lumières intérieures, un verrouillage central, un toit ouvrant, les feux de détresse ou les lumières d'ambiance.

On distingue dans l'état de la technique deux grandes familles technologiques de dalles tactiles.

La première famille concerne les dalles tactiles à détection résistive, réagissant à la pression exercée sur la dalle.

La seconde famille concerne les dalles tactiles à détection capacitive, réagissant à la variation de la capacité d'un champ électrique.

Ces deux familles technologiques présentent des caractéristiques différentes en termes de sensibilité et d'information détectée. Les dalles tactiles à détection résistive pouvant détecter une pression et une localisation, les dalles tactiles à détection capacitive pouvant détecter une approche et une localisation.

Pour tirer pleinement profit des particularités de chacune des deux technologies, il a été proposé de les combiner dans une seule dalle tactile à technologie hybride.

On connait de par le document WO2008/009687 une dalle comportant deux capteurs superposés, l'un résistif et l'autre capacitif, la détection capacitive permettant de détecter l'approche d'un élément au niveau de la dalle et la détection résistive permettant l'activation de la commande sélectionnée.

Cependant cette solution nécessite, du fait de la superposition des deux types de détection, l'utilisation d'un multiplexeur afin de séparer les informations issues des capteurs capacitifs et résistifs, ce qui entraine des augmentations de coût.

De plus, la superposition des deux types détection peut entrainer pour le capteur capacitif une atténuation du champ électrique, ce qui a pour conséquence une sensibilité moindre de ce capteur.

Un des buts de l'invention est donc de proposer un module de commande comprenant une dalle tactile permettant aussi bien une détection d'approche qu'une détection d'appui avec un coût de production optimisé.

Ainsi, la présente invention a pour objet un module de commande comportant au moins une dalle tactile présentant au moins une zone de commande, ladite zone de commande comportant, au moins un premier et un second moyens de détection juxtaposés, dont le premier est formé par un capteur capacitif d'approche et le second est formé par un capteur tactile, ledit module de commande comportant également une unité de traitement configurée pour traiter une première commande en fonction d'un signal du capteur capacitif d'approche et pour traiter une seconde commande en fonction d'un signal du capteur tactile.

La juxtaposition dans une même zone de commande de la détection capacitive d'approche et de la détection tactile supplémentaire crée un effet synergique entre les capteurs qui permet de traiter séparément les informations issues de ces détections sans qu'il y ait besoin d'avoir recours à un multiplexeur.

Selon un aspect du module de commande, la première commande traitée par l'unité de traitement est une commande de sélection et la seconde commande traitée par l'unité de traitement est une commande de validation.

Selon un aspect du module de commande, le capteur tactile est un capteur tactile résistif.

Selon un mode de réalisation du module de commande, la dalle tactile comporte une première et une deuxième couches superposées, espacées par au moins une entretoise, lesdites première et deuxième couches comportant des éléments conducteurs se faisant face formant le capteur tactile résistif, le capteur capacitif d'approche étant juxtaposé aux éléments conducteurs de la première couche.

Selon un aspect du module de commande, les éléments conducteurs sont en oxyde d'indium-étain.

Selon un autre mode de réalisation du module de commande, la dalle tactile comporte une première et une deuxième couche superposées, espacées par au moins une entretoise, la première couche comportant des pistes conductrices entrelacées, la deuxième couche comportant une composition à base de carbone faisant face aux pistes conductrices entrelacées, le capteur capacitif d'approche étant juxtaposé aux pistes conductrices entrelacées de la première couche.

Selon un aspect du module de commande, le capteur capacitif d'approche comprend deux électrodes disposées de part et d'autre du capteur tactile résistif.

Selon un aspect du module de commande, le capteur tactile comporte un capteur capacitif tactile.

Selon un aspect du module de commande, la dalle tactile est au moins partiellement translucide.

Selon un aspect du module de commande, ledit module de commande comporte un film comportant des symboles disposé sur la dalle tactile et des sources lumineuses agencées en dessous de laite dalle tactile de façon à rétroéclairer ledit film.

Selon un aspect du module de commande, l'unité de traitement est configurée pour déclencher le rétroéclairage d'au moins un symbole en réponse à un signal du capteur capacitif d'approche.

Selon un aspect du module de commande, l'unité de traitement est configurée pour, d'une part activer une fonction de commande et d'autre part pour augmenter l'intensité du rétroéclairage en réponse au signal du capteur tactile.

Selon un aspect du module de commande, ledit module de commande comporte plusieurs zones de commande.

D'autres caractéristiques et avantages de l'invention apparaîtront plus clairement à la lecture de la description suivante, donnée à titre d'exemple illustratif et non limitatif, et des dessins annexés parmi lesquels :
- la figure 1 montre un schéma simplifié en vue de côté d'un exemple de module de commande selon un mode de réalisation de l'invention.
- la figure 2 montre un schéma simplifié en vue de côté d'un exemple de dalle tactile selon un mode de réalisation de l'invention,
- la figure 3 montre un schéma simplifié en perspective éclatée d'un exemple de dalle tactile selon un mode de réalisation de l'invention identique à la figure 2,
- la figure 4 montre un schéma simplifié en vue de côté d'un exemple de dalle tactile selon une variante de l'invention,
- la figure 5 montre un schéma simplifié en perspective éclatée d'un exemple de dalle tactile selon une variante de l'invention identique à la figure 4,
- la figure 6 montre un schéma simplifié en perspective éclatée d'un exemple de dalle tactile selon un autre mode de réalisation de l'invention,
- la figure 7 montre un schéma simplifié en perspective d'un exemple de dalle tactile selon un autre mode de réalisation de l'invention.

Sur toutes les figures, les éléments identiques portent les mêmes numéros de référence.

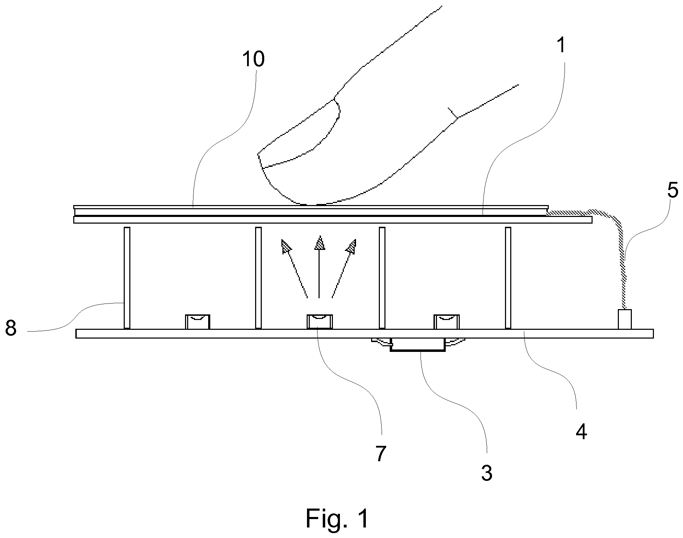

La figure 1 montre un schéma simplifié en vue de côté d'un exemple de module de commande selon un mode de réalisation de l'invention.

On retrouve ici une dalle tactile 1 au moins partiellement translucide, connectée à une unité de traitement 3 des informations, ici un circuit imprimé 4 avec un microprocesseur par exemple. La liaison entre les capteurs de la dalle tactile 1 et l'unité de traitement 3 se fait par exemple au moyen d'un circuit souple de liaison 5. Connectées et commandées par l'unité de traitement 3, on trouve des sources lumineuses 7, par exemple des LED.

Dans l'exemple présenté par la figure 1, le circuit imprimé joue également le rôle de support pour la dalle tactile 1, il soutient ladite dalle tactile 1 au moyen d'entretoises 8.

Les entretoises 8 peuvent également séparer lesdites sources lumineuses 7, ainsi chacune d'elle éclaire une partie différente de la dalle tactile 1 sans que leur lumière ne se mélange.

Un film 10 est appliqué sur ladite dalle tactile 1, il comporte des ouvertures en forme de symboles qui laissent passer la lumière issue des sources lumineuses 7. Chaque symbole peut être rétroéclairé par une source lumineuse 7. Dans l'exemple présenté, chaque symbole est positionné entre les entretoises 8 de séparation et ainsi chaque symbole est rétroéclairé séparément. Les symboles correspondent à une commande activée par le module de commande électronique, ainsi chaque commande est identifiée sur la dalle tactile 1.

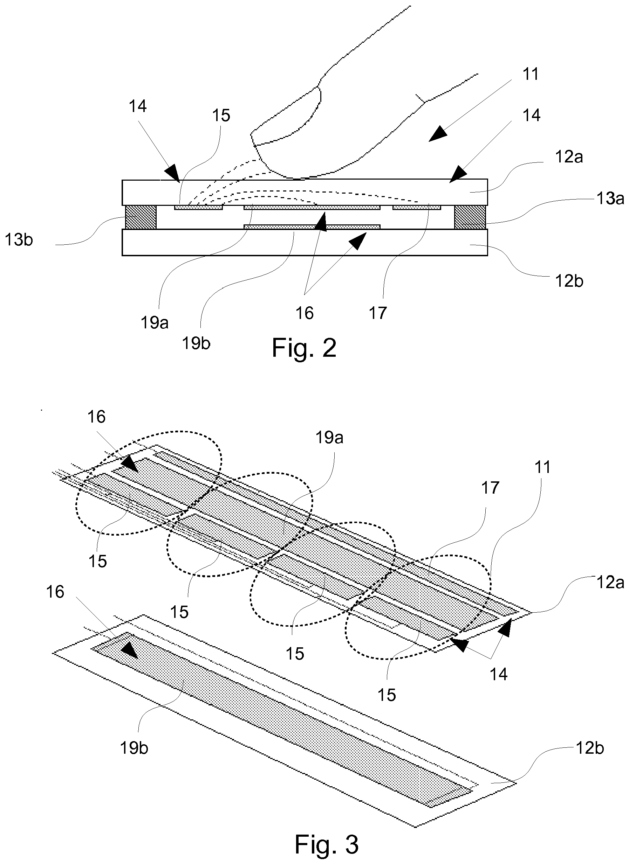

La figure 2 montre un schéma simplifié en vue de côté d'un exemple de dalle tactile 1 selon un mode de réalisation de l'invention.

Cette dalle tactile 1 comporte dans une zone de commande, deux types de capteurs juxtaposés, un capteur capacitif d'approche 14 et un capteur tactile 16.

Par zone de commande 11 on entend une zone contenant une association des deux types de capteurs juxtaposés et où l'utilisateur interagit avec la dalle tactile 1, d'une part par approche et d'autre part de façon tactile.

Il est à noter qu'une ou plusieurs zones de commande 11 peuvent se partager soit un même capteur capacitif d'approche, soit même un capteur tactile.

Selon le mode de réalisation présenté par la figure 2, le capteur capacitif d'approche 14 comporte deux électrodes, une électrode 15 sensitive et une électrode 17 de masse. Ledit capteur capacitif d'approche mesure la variation de la capacité entre les électrodes 15 et 17 lorsque le champ électrique varie à l'approche d'un objet, par exemple le doigt de l'utilisateur.

Le capteur tactile 16 est un capteur tactile résistif 16. Ledit capteur tactile résistif 16 comporte deux éléments conducteurs 19a et 19b, par exemple en oxyde d'indium-étain (ou ITO), dont l'un est porté par une première couche 12a de la dalle tactile 1 et dont l'autre est porté par la seconde couche 12b de ladite dalle tactile 1, les deux couches étant espacées par des entretoises 13a et 13b. Ces couches 12a et 12b sont par exemple réalisé en verre, polycarbonate ou polyéthylène téréphtalate (ou PET). Lesdits éléments conducteurs 19a et 19b se font face à l'intérieur de l'espace crée entre les deux couches 12a et 12b.

La figure 3 montre un schéma simplifié en perspective éclatée de dalle tactile 1 de la figure 2.

On constate que la dalle tactile 1 comporte quatre zones de commande 11.

Ainsi, le capteur capacitif d'approche comporte, dans l'exemple présenté, autant d'électrodes 15 sensitives que de zones de commande 11 et une électrode 17 de masse unique.

Dans l'exemple présenté par les figures 2 et 3, les électrodes 15 et 17 du capteur capacitif d'approche encadrent l'élément conducteur 19a. En variante, selon les contraintes d'implantation mécanique, on peut prévoir que lesdites électrodes soient d'un même côté de l'élément conducteur 19a.

Un appui sur la surface de la première couche 12a entraîne un contact électrique entre les deux éléments conducteurs 19a et 19b, produisant ainsi un état de fermeture électrique. Le niveau de tension captée est proportionnel à l'emplacement de l'appui selon l'axe longitudinal, permettant ainsi la localisation dudit appuis.

Les capteurs capacitifs d'approche et le capteur tactile sont donc juxtaposés, et chacun est géré indépendamment et séparément de l'autre par des circuits de traitement différents. Lesdits circuits de traitement étant réunis au niveau de l'unité de traitement 4 des informations.

Le fonctionnement du module de commande est lié aux caractéristiques de la dalle tactile 1. En effet au repos, les sources de lumière 7 étant éteintes, le module de commande n'est pas rétro éclairé mais demeure visuellement localisable par exemple au moyen de repères visuels sérigraphiés ou réalisés sous forme de bossages. L'utilisateur active le module de commande en approchant, son doigt par exemple, d'une zone de commande 11. Un capteur capacitif d'approche détecte le doigt de l'utilisateur, envoie un signal à l'unité de traitement 4 et celle-ci allume une source lumineuse 7, rétroéclairant un symbole du film 10.

L'utilisateur sélectionne la commande désirée en appuyant sur la zone de commande 11 au niveau du symbole correspondant. Le capteur tactile permet la localisation de l'appui et permet la validation de la commande à activer par l'unité de traitement 3.

La validation est indiquée à l'utilisateur par un sur-éclairage du symbole correspondant. Après un certain temps, l'éclairage de la commande sélectionnée revient à la normale, si aucune nouvelle commande n'est sélectionnée, après un second temps, le module de commande revient à l'état de repos.

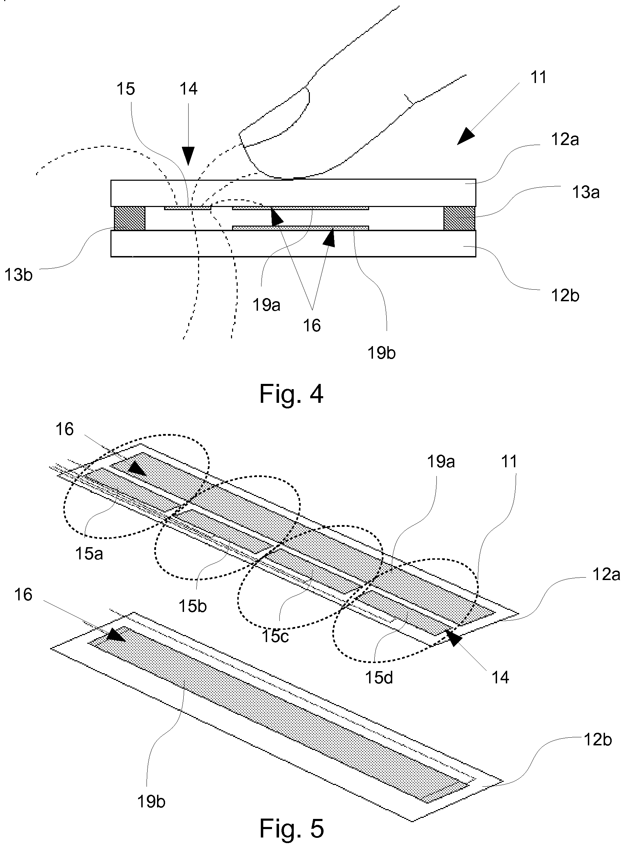

Les figures 4 et 5 montrent une dalle tactile selon une variante. Cette variant se différentie de celle présenté par les figures 2 et 3 par le fait que le capteur capacitif d'approche est un capteur capacitif à une électrode 15 sensitive.

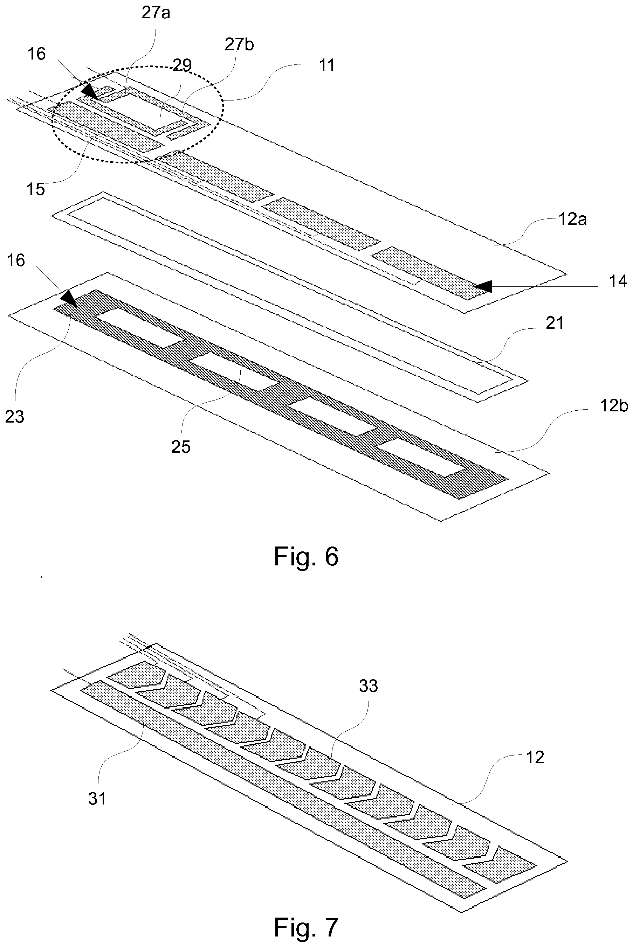

La figure 6 montre un schéma simplifié en perspective d'un exemple de dalle tactile selon un autre mode de réalisation de l'invention.

On retrouve dans ce mode de réalisation une première et une deuxième couche 12a et 12b, espacées par une entretoise 21. Dans l'exemple présenté ladite entretoise 21 est une entretoise ajourée en son centre pour laisser passer la lumière. Le capteur tactile 16 est ici également un capteur tactile résistif 16. Il comporte sur la seconde couche 12b une composition à base de carbone 23. Dans l'exemple présenté par la figure 6, la composition à base de carbone 23 présente des ouvertures 25 permettant le passage de la lumière. Le capteur tactile comporte sur la surface de la première couche 12a, faisant face à la composition à base de carbone 23, comporte des pistes conductrices entrelacées 27a et 27b par exemple réalisées à l'encre d'argent. Ces pistes conductrices entrelacées 27a et 27b comportent, dans ce mode de réalisation, une zone de dégagement centrale 29 par laquelle la lumière peut passer.

Lors d'un appui au niveau desdites pistes conductrices entrelacées 27a et 27b, un contact est fait avec la composition à base de carbone 23. La résistance entre deux pistes conductrices entrelacées 27a et 27b varie en fonction de la pression exercée et en réponse à cette variation, l'unité de traitement 4 active la commande correspondante. Selon le mode de réalisation présenté, il y a autant de groupes de deux pistes conductrices entrelacées 27a et 27b que de zones de commandes 11.

Les ouvertures 25 et zones de dégagement 29 permettent le passage de la lumière, permettant ainsi le rétroéclairage des symboles du film 10 liés aux commandes.

Sur le mode de réalisation présenté par la figure 6, le capteur capacitif d'approche 14 est un capteur capacitif à une seule électrode 15.

La figure 7 montre un schéma simplifié en perspective d'un exemple de dalle tactile selon un autre mode de réalisation de l'invention. Les mêmes éléments que sur les figures précédentes sont présentés par les mêmes numéros de référence.

On retrouve dans ce mode de réalisation une couche 12 comportant un capteur capacitif d'approche 31 et des capteurs tactiles 33. Le capteur capacitif d'approche 31 est un capteur capacitif à une électrode faisant toute la longueur de la dalle tactile. Les capteurs tactiles 33 sont également des capteurs capacitifs à une électrode, il y a autant desdits capteurs tactiles 33 que de zones de commandes.

Le capteur capacitif d'approche 31 a une sensibilité de détection plus importante que les capteurs tactiles 33, ainsi la détection de l'approche par le capteur d'approche 31 se fait sans qu'il y ait besoin de toucher ledit capteur d'approche 31.

Les capteurs tactiles 33 ont une sensibilité de détection bien moindre et il faut que l'utilisateur les touche pour qu'ils détectent le doigt de l'utilisateur.

Dans l'exemple présenté, les capteurs capacitifs de détection 33 forment une série de capteur et peuvent être utilisé pour commander à l'unité de traitement 3 une variation d'un paramètre, par exemple la variation de la température de climatisation.

On comprend donc que la conception du module de commande selon l'invention, ainsi que de la dalle tactile, permet une détection de l'approche d'un objet par un capteur capacitif d'approche et une activation de la commande par un capteur tactile, avec une gestion des coûts optimisés.

## Revendications

1. Module de commande comportant au moins une dalle tactile (1) présentant au moins une zone de commande (11), **caractérisé en ce qu'**il comporte dans la dite au moins une zone de commande (11), au moins un premier et un second moyens de détection juxtaposés, dont le premier est formé par un capteur capacitif d'approche (14) et le second est formé par un capteur tactile (16; 33), et une unité de traitement (4) configurée pour traiter une première commande en fonction d'un signal du capteur capacitif d'approche (15, 17; 31) et pour traiter une seconde commande en fonction d'un signal du capteur tactile (16; 33).

2. Module de commande selon la revendication précédente, **caractérisé en ce que** la première commande traitée par l'unité de traitement (4) est une commande de sélection et la seconde commande traitée par l'unité de traitement (4) est une commande de validation.

3. Module de commande selon l'une des revendications 1 et 2, **caractérisé en ce que** le capteur tactile est un capteur tactile résistif (16).

4. Module de commande selon la revendication 3, **caractérisé en ce que** la dalle tactile (1) comporte une première et une deuxième couches superposées (12a, 12b), espacées par au moins une entretoise (13a, 13b; 21), lesdites première et deuxièmes couches (12a, 12b) comportant des éléments conducteurs (19a, 19b) se faisant face formant le capteur tactile résistif (16), le capteur capacitif d'approche (14) étant juxtaposé aux éléments conducteurs (19a, 19b) de la première couche (12a).

5. Module de commande selon la revendication 4, **caractérisé en ce que** les éléments conducteurs (19a, 19b) sont en oxyde d'indium-étain.

6. Module de commande selon la revendication 3, **caractérisé en ce que** la dalle tactile (1) comporte une première et une deuxième couche superposées (12a, 12b), espacées par au moins une entretoise (21), la première couche (12a) comportant des pistes conductrices entrelacées (27a, 27b), la deuxième couche (12b) comportant une composition à base de carbone (23) faisant face aux pistes conductrices entrelacées (27a, 27b), le capteur capacitif d'approche (15) étant juxtaposé aux pistes conductrices entrelacées (27a, 27b) de la première couche (12a).

7. Module de commande selon la revendication 3 à 6, **caractérisée en ce que** le capteur capacitif d'approche comprend deux électrodes (15, 17) disposées de part et d'autre du capteur tactile résistif (19a, 19b; 27a, 27b, 23).

8. Module de commande selon l'une des revendications 1 et 2, **caractérisé en ce que** le capteur tactile comporte un capteur capacitif tactile (33).

9. Module de commande selon la revendication 1 à 7, **caractérisée en ce que** la dalle tactile (1) est au moins partiellement translucide.

10. Module de commande selon l'une des revendications 9, **caractérisé en ce qu'**il comporte un film (10) comportant des symboles disposé sur la dalle tactile (1) et des sources lumineuses (7) agencées en dessous de laite dalle tactile (1) de façon à rétroéclairer ledit film (10).

11. Module de commande selon la revendication 10, **caractérisé en ce que** l'unité de traitement (3) est configurée pour déclencher le rétroéclairage d'au moins un symbole en réponse à un signal du capteur capacitif d'approche (14; 31).

12. Module de commande selon la revendication 10, **caractérisé en ce que** l'unité de traitement (3) est configurée pour, d'une part activer une fonction de commande et d'autre part pour augmenter l'intensité du rétroéclairage en réponse au signal du capteur tactile (16; 33).

13. Module de commande selon l'une des revendications 1 à 12, **caractérisé en ce qu'**il comporte plusieurs zones de commande (11).

## Patentansprüche

1. Steuermodul, das mindestens einen Touchscreen (1) aufweist, der mindestens einen Steuerbereich (11) hat, **dadurch gekennzeichnet, dass** er in dem mindestens einen Steuerbereich (11) mindestens eine erste und eine zweite nebeneinander angeordnete Erfassungseinrichtung, von denen die erste von einem kapazitiven Näherungssensor (14) und die zweite von einem Berührungssensor (16; 33) gebildet wird, und eine Verarbeitungseinheit (4) aufweist, die konfiguriert ist, einen ersten Steuerbefehl abhängig von einem Signal des kapazitiven Näherungssensors (15, 17; 31) zu verarbeiten und einen zweiten Steuerbefehl abhängig von einem Signal des Berührungssensors (16; 33) zu verarbeiten.

2. Steuermodul nach dem vorhergehenden Anspruch, **dadurch gekennzeichnet, dass** der erste von der Verarbeitungseinheit (4) verarbeitete Steuerbefehl ein Auswahlbefehl und der zweite von der Verarbeitungseinheit (4) verarbeitete Steuerbefehl ein Validierungsbefehl ist.

3. Steuermodul nach einem der Ansprüche 1 und 2, **dadurch gekennzeichnet, dass** der Berührungssensor ein resistiver Berührungssensor (16) ist.

4. Steuermodul nach Anspruch 3, **dadurch gekennzeichnet, dass** der Touchscreen (1) einer erste und eine zweite übereinanderliegende Schicht (12a, 12b) aufweist, die durch mindestens einen Abstandshalter (13a, 13b; 21) beabstandet werden, wobei die erste und die zweite Schicht (12a, 12b) einander gegenüberliegende leitende Elemente (19a, 19b) aufweisen, die den resistiven Berührungssensor (16) bilden, wobei der kapazitive Näherungssensor (14) neben den leitenden Elementen (19a, 19b) der ersten Schicht (12a) angeordnet ist.

5. Steuermodul nach Anspruch 4, **dadurch gekennzeichnet, dass** die leitenden Elemente (19a, 19b) aus Indium-Zinn-Oxid sind.

6. Steuermodul nach Anspruch 3, **dadurch gekennzeichnet, dass** der Touchscreen (1) eine erste und eine zweite übereinanderliegende Schicht (12a, 12b) aufweist, die durch mindestens einen Abstandshalter (21) beabstandet werden, wobei die erste Schicht (12a) ineinander verschachtelte Leiterbahnen (27a, 27b) aufweist, wobei die zweite Schicht (12b) eine Zusammensetzung auf der Basis von Kohlenstoff (23) aufweist, die den verschachtelten Leiterbahnen (27a, 27b) gegenüberliegt, wobei der kapazitive Näherungssensor (15) neben den verschachtelten Leiterbahnen (27a, 27b) der ersten Schicht (12a) liegt.

7. Steuermodul nach Anspruch 3 bis 6, **dadurch gekennzeichnet, dass** der kapazitive Näherungssensor zwei Elektroden (15, 17) enthält, die zu beiden Seiten des resistiven Berührungssensors (19a, 19b; 27a, 27b, 23) angeordnet sind.

8. Steuermodul nach einem der Ansprüche 1 und 2, **dadurch gekennzeichnet, dass** der Berührungssensor einen kapazitiven Berührungssensor (33) aufweist.

9. Steuermodul nach Anspruch 1 bis 7, **dadurch gekennzeichnet, dass** der Touchscreen (1) zumindest teilweise durchscheinend ist.

10. Steuermodul nach einem der Ansprüche 9, **dadurch gekennzeichnet, dass** es eine auf dem Touchscreen (1) angeordnete, Symbole aufweisende Folie (10) und Lichtquellen (7) aufweist, die unter dem Touchscreen (1) angeordnet sind, um die Folie (10) von hinten zu beleuchten.

11. Steuermodul nach Anspruch 10, **dadurch gekennzeichnet, dass** die Verarbeitungseinheit (3) konfiguriert ist, die Hintergrundbeleuchtung mindestens eines Symbols als Reaktion auf ein Signal des kapazitiven Näherungssensors (14; 31) auszulösen.

12. Steuermodul nach Anspruch 10, **dadurch gekennzeichnet, dass** die Verarbeitungseinheit (3) konfiguriert ist, einerseits eine Steuerfunktion zu aktivieren und andererseits die Stärke der Hintergrundbeleuchtung als Reaktion auf das Signal des Berührungssensors (16; 33) zu erhöhen.

13. Steuermodul nach einem der Ansprüche 1 bis 12, **dadurch gekennzeichnet, dass** es mehrere Steuerbereiche (11) aufweist.

## Claims

1. Control module including at least one touch panel (1) comprising at least one control zone (11), **characterized in that** it includes, in said at least one control zone (11), at least one first and one second juxtaposed detecting means, the first of which is formed by a capacitive proximity sensor (14) and the second is formed by a touch sensor (16; 33), and a processing unit (4) configured to process a first command depending on a signal from the capacitive proximity sensor (15, 17; 31) and to process a second command depending on a signal from the touch sensor (16; 33).

2. Control module according to the preceding claim, **characterized in that** the first command processed by the processing unit (4) is a selection command and the second command processed by the processing unit (4) is a validation command.

3. Control module according to either of Claims 1 and 2, **characterized in that** the touch sensor is a resistive touch sensor (16).

4. Control module according to Claim 3, **characterized in that** the touch panel (1) includes a first and a second layer (12a, 12b) which are superposed and spaced apart by at least one spacer (13a, 13b; 21), said first and second layers (12a, 12b) including mutually facing conductive elements (19a, 19b) forming the resistive touch sensor (16), the capacitive proximity sensor (14) being juxtaposed with the conductive elements (19a, 19b) of the first layer (12a).

5. Control module according to Claim 4, **characterized in that** the conductive elements (19a, 19b) are made of indium tin oxide.

6. Control module according to Claim 3, **characterized in that** the touch panel (1) includes a first and a second layer (12a, 12b), which are superposed and spaced apart by at least one spacer (21), the first layer (12a) including interlaced conductive tracks (27a, 27b) and the second layer (12b) including a carbon-based composition (23) facing the interlaced conductive tracks (27a, 27b), the capacitive proximity sensor (15) being juxtaposed with the interlaced conductive tracks (27a, 27b) of the first layer (12a).

7. Control module according to Claim 3 to 6, **characterized in that** the capacitive proximity sensor comprises two electrodes (15, 17) placed on either side of the resistive touch sensor (19a, 19b; 27a, 27b, 23).

8. Control module according to either of Claims 1 and 2, **characterized in that** the touch sensor includes a capacitive touch sensor (33).

9. Control module according to Claim 1 to 7, **characterized in that** the touch panel (1) is at least partially translucent.

10. Control module according to one of Claims 9, **characterized in that** it includes a film (10) including symbols, which film is placed on the touch panel (1), and light sources (7) arranged below said touch panel (1) so as to backlight said film (10).

11. Control module according to Claim 10, **characterized in that** the processing unit (3) is configured to trigger the backlighting of at least one symbol in response to a signal from the capacitive proximity sensor (14; 31).

12. Control module according to Claim 10, **characterized in that** the processing unit (3) is configured to on the one hand activate a control function and on the other hand increase the brightness of the backlighting in response to the signal from the touch sensor (16; 33).

13. Control module according to one of Claims 1 to 12, **characterized in that** it includes a plurality of control zones (11).
